# EUROPEAN PATENT SPECIFICATION

(11) **EP 3 711 631 B1**
(45) Date of publication and mention of the grant of the patent: **16.09.2026**
(21) Application number: 20155034.0
(22) Date of filing: 31.01.2020
(51) Int. Cl.: A47B 96/06, H05K 7/14

(54) **ELECTRICAL EQUIPMENT WITH A HANGING BRACKET**
ELEKTRISCHES GERÄT MIT EINER AUFHÄNGEVORRICHTUNG
ÉQUIPEMENT ÉLECTRIQUE AVEC UN SUPPORT DE SUSPENSION

(30) Priority: 20.03.2019 CN 201910214112
(43) Date of publication of application: 23.09.2020
(73) Proprietor: Sungrow Power Supply Co., Ltd., Hefei, Anhui 230088 (CN)
(72) Inventor: Shen, Zhanliang, Hefei, Anhui 230088 (CN); Huang, Zhifeng, Hefei, Anhui 230088 (CN)
(74) Representative: Zhu, Puxing

(56) References cited:
- US-A- 4 285 484
- US-A- 4 687 170
- US-A1- 2004 108 289
- US-A1- 2018 110 346

## Description

### FIELD

The present application relates to an electrical equipment having a case bracket

### BACKGROUND

An electrical structure is usually mounted in a case body of a case, such as an inverter case. A handle is usually provided on a side wall of the case for facilitating staff carrying. A hanging device is usually provided on a rear wall of the case. The inverter is connected to a wall hanging plate through the hanging device, so as to achieve the hanging mounting of the inverter.

Specifically, mounting locations are provided on a side and a rear wall of the case, and a handle and a hanging device are separately mounted by the staff.

US2018/110346A1 discloses a wall-mountable bracket including a mounting arm that can be used to attach the wall-mountable bracket to a structure. The wall-mountable bracket can also include a support arm that extends from the mounting arm and extends away from the structure when the wall-mountable bracket is attached to the structure. The support arm can include one or more openings that can receive one or more items to allow the wall-mountable bracket to support the various items. For example, the support arm can include an opening that includes a rounded surface that can receive and support one or more tubes or rods having circular cross-section or the support arm can include an opening that includes a substantially flat surface that can receive and support a horizontally arranged piece of lumber.

### SUMMARY

An electrical equipment is provided by the present application.

The electrical equipment provided according to the present application is an inverter or a combiner box, and the electrical equipment includes a case body, where the electric equipment further includes a case bracket fixedly connected to the case body and configured to allow the case body to be hung up. The case bracket includes: a main body frame, a handle portion provided on the main body frame, and a hanging device provided on the main body frame. The main body frame includes a mounting portion for fixedly connecting to the case body and support legs fixedly connected to the mounting portion, and the hanging device is mounted on the support legs. The support legs are configured to: support the case body when the case body is laid flat, and hung up the case body by using the hanging device when the case body is hung up.

Preferably, the handle portion is a handle protrusion protruding outward from the mounting portion, and the handle protrusion and the mounting portion are formed as an integral structure.

Preferably, the handle portion is an operation hole provided in the mounting portion.

Preferably, the operation hole is provided along a length direction of the mounting portion.

Preferably, the operation hole is an oblong hole.

According to the invention, the main body frame further includes two support legs fixedly connected to the mounting portion, the two support legs are arranged along the length direction of the mounting portion, two hanging devices are provided, and the two hanging devices are respectively mounted on the support legs.

According to the invention, the hanging device is a hanging protrusion or a hanging recess configured to allow the case body to be hung up.

Preferably, the hanging device and the support leg are formed as an integral structure.

Preferably, an end of the hanging device facing away from the mounting portion is a support surface, and the support surface protrudes outward from a side of the case.

Preferably, the hanging device is detachably connected to the support leg.

Preferably, the main body frame further includes a reinforcing rib plate having two ends connected to the support leg and the mounting portion, respectively.

Preferably, two case brackets are provided, and the two case brackets are symmetrically arranged on opposite sides of the case body.

In the above technical solution, the case bracket according to the present application includes a main body frame, a handle portion provided on the main body frame, and a hanging device provided on the main body frame.

From the above description, it can be known that, in the case bracket according to the present application, the hanging device and the handle portion are both provided on the main body frame to achieve an integrated setting, thereby effectively improving the mounting efficiency of the case bracket.

### BRIEF DESCRIPTION OF THE DRAWINGS

For clearer illustration of the technical solutions according to embodiments of the present application or conventional techniques, hereinafter are briefly described the drawings to be applied in embodiments of the present application or conventional techniques. Apparently, the drawings in the following descriptions are only some embodiments of the present application, and other drawings may be obtained by those skilled in the art based on the provided drawings without creative efforts.
Figure 1 is a schematic view showing the structure of a case bracket according to a first embodiment of the present application;
Figure 2 is a schematic view showing the structure of the case bracket shown in Figure 1 when the case bracket supports the case;
Figure 3 is a schematic view showing the structure of the case bracket shown in Figure 2 in a supporting state;
Figure 4 is a structural position view of the case shown in Figure 2 and a wall hanging plate;
Figure 5 is a structural position view of the case when the case as shown in Figure 2 is vertically mounted;
Figure 6 is a structural position view of the case when the case as shown in Figure 2 is horizontally carried;
Figure 7 is a three-dimensional structure view of the case shown in Figure 2;
Figure 8 is a three-dimensional structural view of a case bracket according to a second embodiment of the present application;
Figure 9 is a three-dimensional structural view of a case bracket according to a third embodiment of the present application; and
Figure 10 is a structural position view of the case shown in Figure 8 and the wall hanging plate.

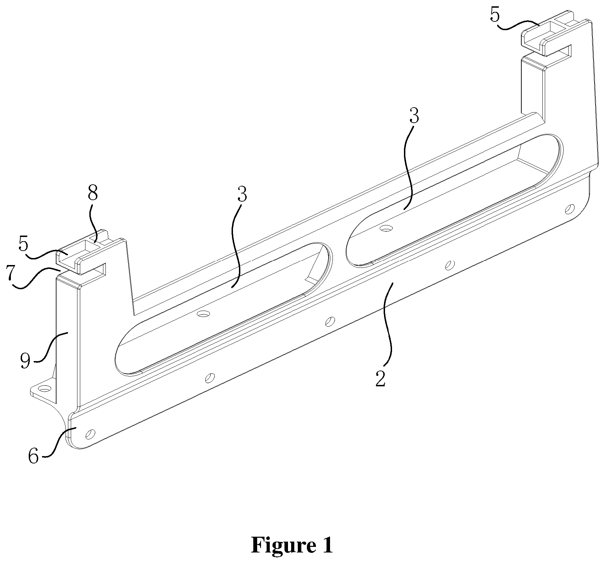

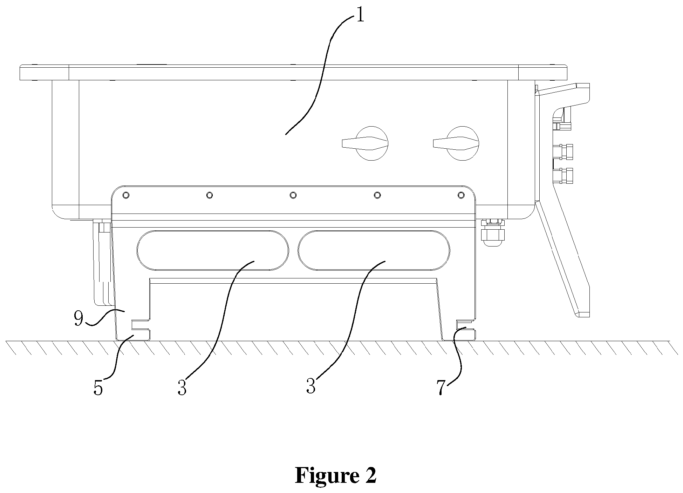

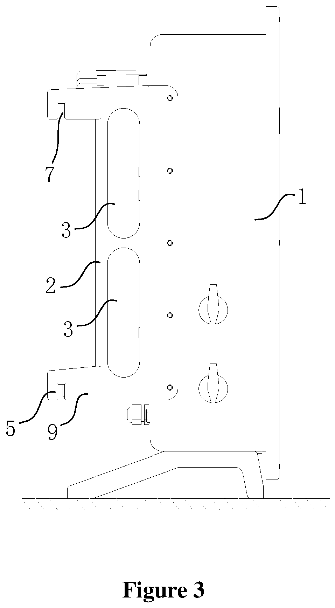

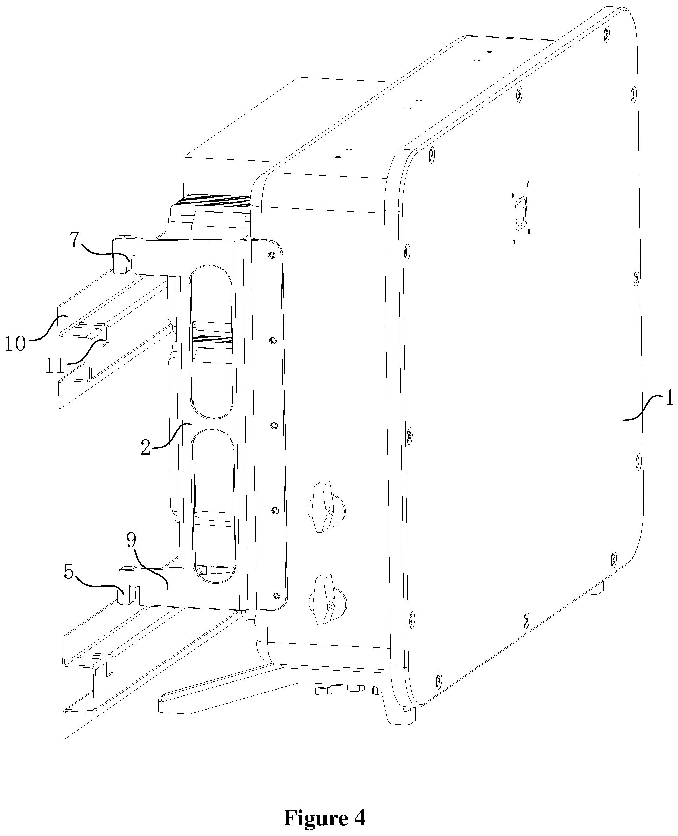

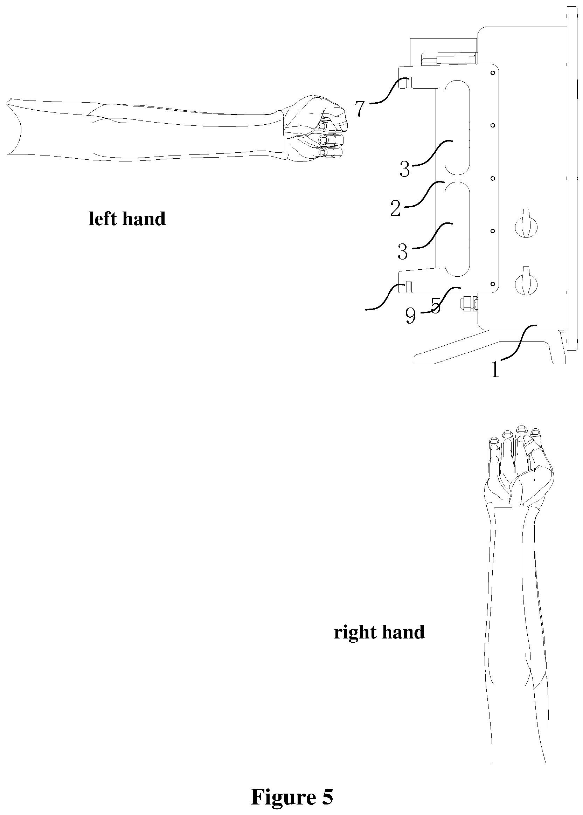

Reference numerals in Figures 1 to 10.

| | | | |
|---|---|---|---|
| 1 | case body, | 2 | main body frame, |
| 3 | operation hole, | 4 | reinforcing rib plate, |
| 5 | hanging device, | 6 | mounting portion, |
| 7 | hanging recess, | 8 | supporting plate, |
| 9 | support leg, | 10 | wall hanging plate, |
| 11 | limiting hole, | 12 | case body bracket, |
| 13 | case bracket. | | |

### DETAILED DESCRIPTION

A case bracket is provided by the present application for improving the mounting efficiency of the case bracket. A case having the case bracket is further provided by the present application.

In order to make those skilled in the art to better understand the solution of the present application, the present application will be further described in detail below in conjunction with the drawings and specific embodiments.

Please refer to Figures 1 to 10.

In a specific embodiment, a case bracket according to the specific embodiment of the present application includes a main body frame 2, a handle portion provided on the main body frame 2, and a hanging device 5 provided on the main body frame 2.

The hanging device 5 may be a conventional hook. The hanging device 5 may be a hanging protrusion or a hanging recess 7 that allows the case body to be hung up. The case body is connected to the wall hanging plate 10 through the hanging recess 7 to achieve the hanging of the case. Specifically, the wall hanging plate 10 is provided with a limiting hole 11 for limiting the hanging device 5. The structure of the hanging device 5 may be adaptively designed according to the structure of the wall hanging plate 10, which is not limited to two embodiments. The wall hanging function may be achieved by a single case bracket 13, or two case brackets 13 on opposite sides of the case body 1 together with other parts.

Specifically, the handle portion may be one or more hanging ring mounted on the main body frame 2, which depends on actual requirements. The handle portion may be handled by human hands for carrying and mounting the case.

Further, the main body frame 2 includes a mounting portion 6 for fixedly connecting with the case body 1. Specifically, the mounting portion 6 may be detachably connected to the case body 1. In an actual application, when the case bracket 13 may be integrally formed with the casing of the case body 1, the mounting portion 6 is a part of the casing of the case body 1, that is, the mounting portion 6 is not required to be individually provided.

The handle portion is a handle protrusion protruding outward from the mounting portion 6, and the handle protrusion and the mounting portion 6 are formed as an integral structure. Specifically, during processing, the integral structure of the handle protrusion and the mounting portion 6 may be formed by extrusion.

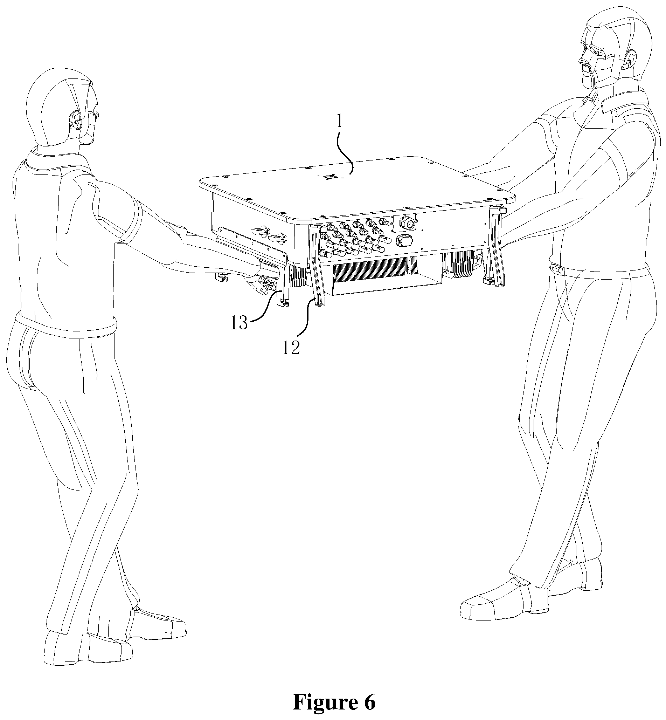

In order to improve the processing efficiency of the case bracket 13, preferably, the handle portion is an operation hole 3 provided in the mounting portion 6, and specifically, the number of the operation hole 3 may be one, two or more. Considering that an operator usually uses both hands when carrying the case, as shown in Figure 6, preferably, the number of the operation holes 3 are two. In order to facilitate arranging the operation holes 3 and reducing the overall area, the operation holes 3 are preferably provided along a length direction of the mounting portion 6.

As shown in Figures 1 to 3, in order to avoid the situations of the local stress concentration of the operation hole 3 and scratching the operator, the operation hole 3 is preferably an oblong hole.

Specifically, when the case bracket 13 is mounted, the case body 1 is vertically placed and supported by the case body bracket 12 of the case body 1, and then the case bracket 13 is mounted on the case body 1 through a locking member. Specifically, the locking member is preferably a threaded fastener.

From the above description, it can be known that, in the case bracket according to the specific embodiment of the present application, the hanging device 5 and the handle portion are both provided on the main body frame 2 to achieve an integrated setting, and the main body frame 2 is directly mounted with the case body, that is, achieving the mounting of the handle portion and the hanging device 5 with the case, thereby the mounting efficiency of the case bracket 13 is effectively improved.

Further, the main body frame 2 further includes two support legs 9 fixedly connected to the mounting portion 6. The two support legs 9 are arranged along the length direction of the mounting portion 6. Two hanging devices 5 are provided and are respectively mounted on the two support leg 9. With the setting of the support legs 9, it is convenient for the hanging device 5 to better achieve the hanging, the overall structural layout is more reasonable, and interference between operations is avoided.

In order to improve the processing efficiency of the case bracket 13 and reduce the labor intensity of the staff in assembling the case bracket 13, the hanging device 5 and the support leg 9 are preferably formed as an integral structure.

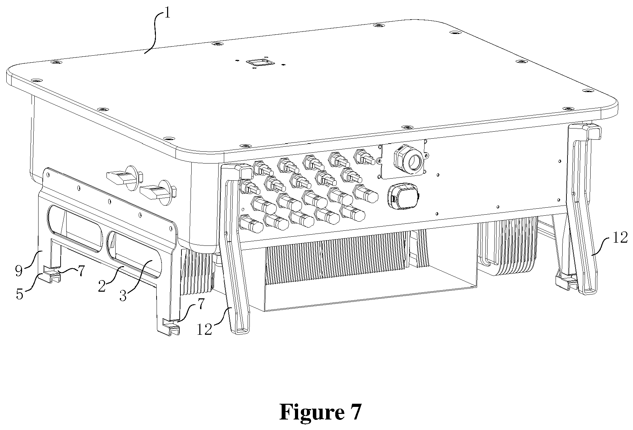

Preferably, an end of the hanging device 5 facing away from the mounting portion 6 is a support surface, and the support surface protrudes outwards from a side of the case body. When the case body is laid flat, as shown in Figure 7, the case body 1 may be supported by the end of the hanging device 5. Specifically, in order to prolong the service life of the case bracket 13, a support plate 8 is preferably provided on the support surface.

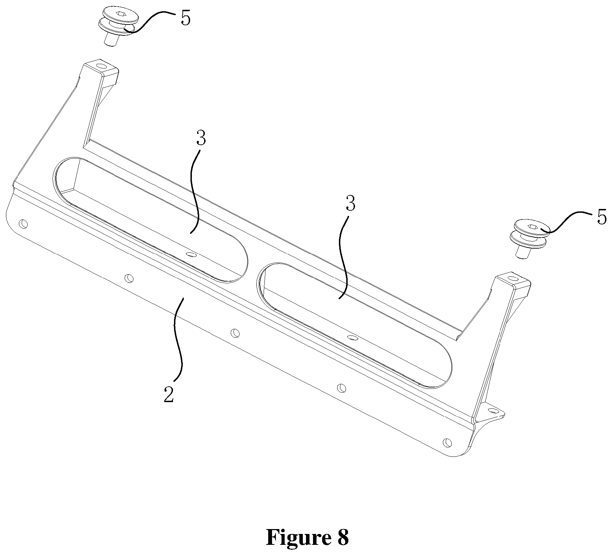

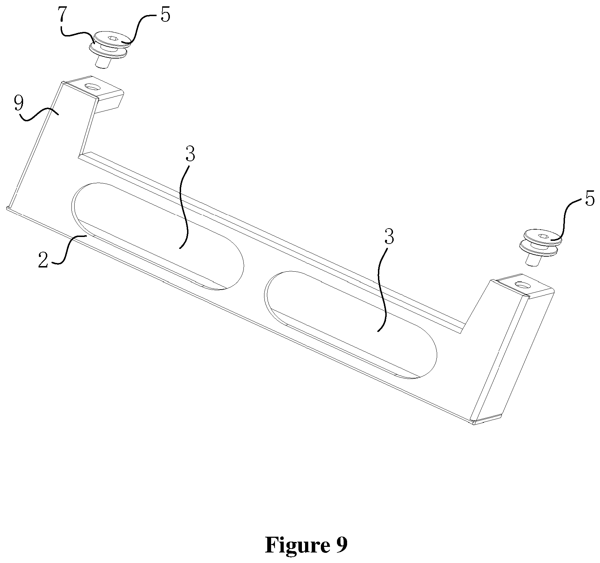

In another embodiment, as shown in Figures 8 to 10, for example, the second case body bracket shown in Figure 8 and the third case body bracket shown in Figure 9, the hanging device 5 is detachably connected to the support leg 9. Specifically, in order to facilitate disassembly of the hanging device 5, the hanging device 5 and the support leg 9 are separated into two parts. Preferably, the hanging device 5 is connected to the support leg 9 by threads.

In order to improve the use stability of the case bracket 13 and prolong the service life of the case bracket 13, preferably, the main body frame 2 further includes a reinforcing rib plate 4 having two ends connected to the support legs 9 and the mounting portion 6, respectively. The shape and number of the reinforcing rib plates 4 are determined according to the actual requirements, which are not specifically limited in this application.

Preferably, the main body frame 2 is formed as an integral structure. More preferably, the case bracket 13 is formed as an integral structure, thereby reducing the number of the parts of the case bracket 13, and the handle portion is simply the operation hole 3, which avoids the situation of individually providing a handle structure, reduces costs, and reduces assembly difficulty.

The case bracket 13 according to the present application integrates multiple functions such as carrying, wall hanging and supporting, which is easy to operate, convenient to widespread use, simplifies the number of the parts and reduces costs.

Electrical equipment according to the present application includes a case body 1 and a case bracket 13 which is fixedly connected to the case body 1 and used to achieve the hanging of the case body 1, and the case bracket 13 is any one of the above case brackets 13. The specific structure and technical effects of the case bracket 13 have been described above. The case body according to the present application includes the above case bracket 13 and also has the above technical effects.

Specifically, the electrical equipment may be an inverter or a combiner box. Of course, in specific applications, the case bracket 13 may also be used for hanging other electrical devices.

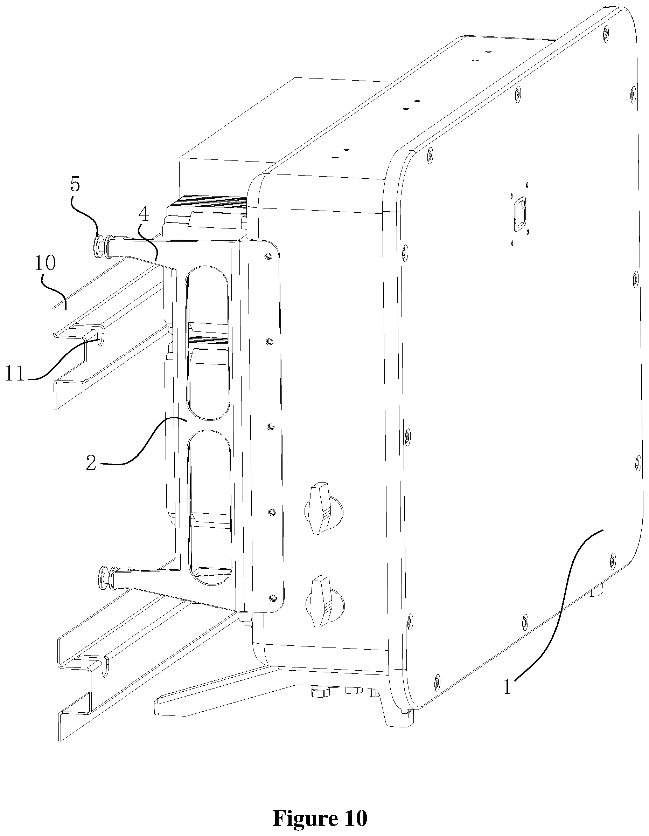

In order to ensure the stability of the hanging of the case, preferably, two case brackets 13 are provided, and the two case brackets 13 are symmetrically arranged on opposite sides of the case body 1. More preferably, as shown in Figure 10, after hanging, the length direction of the mounting portion 6 is arranged perpendicular to the horizontal direction.

The above embodiments are described in a progressive manner. Each of the embodiments is mainly focused on describing its differences from other embodiments, and references may be made among these embodiments with respect to the same or similar sections among these embodiments.

Based on the above description of the disclosed embodiments, the person skilled in the art can carry out or use the present application. It is obvious for the person skilled in the art to make many modifications to these embodiments within the scope of the claims. The general principle defined herein may be applied to other embodiments without departing from the scope of the present application. Therefore, the present application is not limited to the embodiments illustrated herein, but should be defined by the broadest scope consistent with the claims.

## Claims

1. An electrical equipment, the electrical equipment being an inverter or a combiner box, and comprising a case bracket (13) and a case body (1), wherein the case bracket (13) is fixedly connected to the case body (1) and configured to allow the case body (1) to be hung up, and
wherein the case bracket comprises a main body frame (2), a handle portion provided on the main body frame (2), and a hanging device (5) provided on the main body frame (2),
wherein the main body frame (2) comprises a mounting portion (6) fixedly connecteded to the case body (1),
two support legs (9) fixedly connected to the mounting portion (6), the two support legs (9) being arranged along the length direction of the mounting portion (6), and
two hanging devices (5), the two hanging devices (5) being respectively mounted on the two support legs (9), and
wherein the hanging device (5) is provided with a hanging protrusion or a hanging recess (7) configured to allow the case body to be hung up.

2. The electrical equipment according to claim 1, wherein the handle portion is a handle protrusion protruding outward from the mounting portion (6), and the handle protrusion and the mounting portion (6) are formed as an integral structure.

3. The electrical equipment according to claim 1, wherein the handle portion is an operation hole (3) provided in the mounting portion (6).

4. The electrical equipment according to claim 3, wherein the operation hole (3) is provided along a length direction of the mounting portion (6).

5. The electrical equipment according to claim 3, wherein the operation hole (3) is an oblong hole.

6. The electrical equipment according to claim 1, wherein the hanging device (5) and the support leg (9) are formed as an integral structure.

7. The electrical equipment according to claim 6, wherein an end of the hanging device (5) facing away from the mounting portion (6) is a support surface, and the support surface protrudes outward from a side of the case.

8. The electrical equipment according to claim 1, wherein the hanging device (5) is detachably connected to the support leg (9).

9. The electrical equipment according to claim 1, wherein the main body frame (2) further comprises a reinforcing rib plate (4) having two ends connected to the support leg (9) and the mounting portion (6), respectively.

10. The electrical equipment according to claim 1, wherein two case brackets (13) are provided, and the two case brackets (13) are symmetrically arranged on opposite sides of the case body (1).

## Patentansprüche

1. Elektrische Vorrichtung, wobei es sich bei der elektrischen Vorrichtung um einen Wechselrichter oder eine Combiner-Box handelt und die elektrische Vorrichtung eine Gehäusehalterung (13) und einen Gehäusekörper (1) umfasst, wobei die Gehäusehalterung (13) fest mit dem Gehäusekörper (1) verbunden und so ausgebildet ist, dass der Gehäusekörper (1) aufgehängt werden kann, und
wobei die Gehäusehalterung einen Hauptrahmen (2), einen am Hauptrahmen (2) vorgesehenen Griffabschnitt und eine am Hauptrahmen (2) vorgesehene Aufhängevorrichtung (5) umfasst,
wobei der Hauptrahmen (2) einen Befestigungsabschnitt (6) umfasst, der fest mit dem Gehäusekörper (1) verbunden ist,
zwei Stützbeine (9), die fest mit dem Befestigungsabschnitt (6) verbunden sind, wobei die beiden Stützbeine (9) entlang der Längsrichtung des Befestigungsabschnitts (6) angeordnet sind, sowie
zwei Aufhängevorrichtungen (5), wobei die beiden Aufhängevorrichtungen (5) jeweils an den beiden Stützbeinen (9) angebracht sind, und
wobei die Aufhängevorrichtung (5) mit einem Aufhängevorsprung oder einer Aufhängausnehmung (7) versehen ist, die so ausgebildet ist, dass der Gehäusekörper aufgehängt werden kann.

2. Elektrische Vorrichtung nach Anspruch 1, wobei der Griffabschnitt ein vom Befestigungsabschnitt (6) nach außen ragender Griffvorsprung ist und der Griffvorsprung und der Befestigungsabschnitt (6) als einstückige Struktur ausgebildet sind.

3. Elektrische Vorrichtung nach Anspruch 1, wobei der Griffabschnitt eine im Befestigungsabschnitt (6) vorgesehene Bedienungsöffnung (3) ist.

4. Elektrische Vorrichtung nach Anspruch 3, wobei die Bedienungsöffnung (3) entlang einer Längsrichtung des Befestigungsabschnitts (6) vorgesehen ist.

5. Elektrische Vorrichtung nach Anspruch 3, wobei die Bedienungsöffnung (3) eine längliche Öffnung ist.

6. Elektrische Vorrichtung nach Anspruch 1, wobei die Aufhängevorrichtung (5) und das Stützbein (9) als einstückige Struktur ausgebildet sind.

7. Elektrische Vorrichtung nach Anspruch 6, wobei ein vom Befestigungsabschnitt (6) abgewandtes Ende der Aufhängevorrichtung (5) eine Auflagefläche bildet und die Auflagefläche von einer Seite des Gehäuses nach außen vorsteht.

8. Elektrische Vorrichtung nach Anspruch 1, wobei die Aufhängevorrichtung (5) lösbar mit dem Stützbein (9) verbunden ist.

9. Elektrische Vorrichtung nach Anspruch 1, wobei der Hauptrahmen (2) ferner eine Verstärkungsrippenplatte (4) umfasst, deren beide Enden jeweils mit dem Stützbein (9) bzw. dem Befestigungsabschnitt (6) verbunden sind.

10. Elektrische Vorrichtung nach Anspruch 1, wobei zwei Gehäusehalterungen (13) vorgesehen sind und die beiden Gehäusehalterungen (13) symmetrisch auf gegenüberliegenden Seiten des Gehäusekörpers (1) angeordnet sind.

## Revendications

1. Équipement électrique, ledit équipement électrique étant un onduleur ou un boîtier de raccordement, et comprenant un support de boîtier (13) et un corps de boîtier (1), dans lequel le support de boîtier (13) est relié de manière fixe au corps de boîtier (1) et est configuré pour permettre la suspension du corps de boîtier (1), et
dans lequel le support de boîtier comprend un châssis principal (2), une partie de poignée prévue sur le châssis principal (2), et un dispositif de suspension (5) prévu sur le châssis principal (2),
dans lequel le châssis principal (2) comprend une partie de montage (6) reliée de manière fixe au corps de boîtier (1),
deux pieds de support (9) reliés de manière fixe à la partie de montage (6), les deux pieds de support (9) étant disposés dans le sens de la longueur de la partie de montage (6), et
deux dispositifs de suspension (5), les deux dispositifs de suspension (5) étant respectivement montés sur les deux pieds de support (9), et
dans lequel le dispositif de suspension (5) est muni d'une saillie de suspension ou d'un évidement de suspension (7) configuré pour permettre de suspendre le corps de boîtier.

2. Équipement électrique selon la revendication 1, dans lequel la partie de poignée est une saillie de poignée faisant saillie vers l'extérieur à partir de la partie de montage (6), et la saillie de poignée et la partie de montage (6) sont formées en une structure monobloc.

3. Équipement électrique selon la revendication 1, dans lequel la partie de poignée est un orifice de commande (3) prévu dans la partie de montage (6).

4. Équipement électrique selon la revendication 3, dans lequel l'orifice de commande (3) est prévu dans le sens de la longueur de la partie de montage (6).

5. Équipement électrique selon la revendication 3, dans lequel l'orifice de commande (3) est un orifice oblong.

6. Équipement électrique selon la revendication 1, dans lequel le dispositif de suspension (5) et le pied de support (9) sont formés en une structure monobloc.

7. Équipement électrique selon la revendication 6, dans lequel une extrémité du dispositif de suspension (5) opposée à la partie de montage (6) constitue une surface d'appui, et ladite surface d'appui fait saillie vers l'extérieur à partir d'un côté du boîtier.

8. Équipement électrique selon la revendication 1, dans lequel le dispositif de suspension (5) est relié de manière amovible au pied de support (9).

9. Équipement électrique selon la revendication 1, dans lequel le châssis principal (2) comprend en outre une plaque à nervures de renfort (4) dont les deux extrémités sont reliées respectivement au pied de support (9) et à la partie de montage (6).

10. Équipement électrique selon la revendication 1, dans lequel deux supports de boîtier (13) sont prévus, et les deux supports de boîtier (13) sont disposés symétriquement sur les côtés opposés du corps de boîtier (1).
